# EUROPEAN PATENT APPLICATION

(11) **EP 2 469 430 A1**
(43) Date of publication of application: **27.06.2012**
(21) Application number: 10196554.9
(22) Date of filing: 22.12.2010
(51) Int. Cl.: G06F 17/50

(54) **Method and system for analysis of an object**

(71) Applicant: University of Limerick, Limerick (IE)
(72) Inventor: Kinsella Christopher, Listowel, Co. Kerry (IE); Moore, Thomas Daniel, Monaleen, Co. Limerick (IE); Jarvis John, Monaleen, Co. Limerick (IE)
(74) Representative: Lucey, Michael

(57) **Abstract**

The invention provides a method and system for analysing the mechanical stress of an object using a computing device to any desired accuracy and special resolution with certainty, said method comprising the steps of arranging a plurality of values representative of stress descriptors of said object, having a plurality of rows and columns of values; applying a different scaling factor to each row and applying a different scaling factor to each column; generating an array from said scaled rows and columns; storing the scaling factors for each row and each column; processing the scaled array to incorporating boundary conditions and thereby provide system unknowns; and determining stress values of said object from said stress descriptors by removing any errors of said processed array by using one or more of said stored scaling factors. The method of scaling which uses differing scales for individual rows of the arrays, and by further using differing scales for individual columns of the arrays allows for the removal of errors in the calculation of stress values so that the accuracy of the resultant stress distribution may be known with certainty.

## Description

### Field of the Invention

The present invention relates to a method and system for analysis of an object, for example a mechanical system. In particular the invention relates to a method of stress analysis of mechanical systems using limited computer hardware resources.

### Background to the Invention

Many engineering structures are composed of layers of differing materials. Examples range in size from the wings of giant aircraft to the layers on the surface of microchips. Stresses arise between these layers which may damage a functional layer (as in microchips) or cause separation of the layers (as in aircraft wing structures). A system and method of producing analyses of the distributions of these stresses in which the accuracy of the stress values is high and determinate is desirable. The systems and methods currently in use are of limited and uncertain accuracy because some representations of stresses which they generate are either of limited or of indeterminate accuracy.

These representations are stored in a computing device as arrays. It is not possible to apply universal scaling factors to arrays so as to bring the representations of the stresses within the limitations of a computing device because columnar scaling of arrays causes inherent errors.

A variety of computer implemented techniques have evolved to refine the analysis of stress fields near singularities. These cover the full range of analytic approaches, particularly in finite element analysis, and in advanced mathematics computational methods. Dundur's parameter singularity analysis is used by a number of authors; however this analysis method only deals with the singularity region. A method of examining stress distributions throughout a structure with confidence in both precision of location and pre-determined high accuracy is desirable.

Finite element analysis (FEA) meshes can be made more dense (h-elements), or the element equation order increased (p-elements), to counter the problems raised by singularities, at the expense of processing time. However, the effect of the singularity cannot be predicted accurately in FEA. Most FEA analytic models suffer from assumptions and solutions which are not derived from first principles. These models often do not meet basic requirements of the beam, such as zero shear stress at the free edge. More accurate solutions result in overly complex and unwieldy solution forms.

A first principles model has been examined as a possible solution to these weaknesses in other models. The method was based around an infinite series of complex terms, which when summed give the exact solution. For practical purposes the infinite series must be truncated. The accuracy of the method can be calculated based on the number of terms retained in the truncated series. For this method to deal successfully with stress in regions close to singularities, a large number of terms is needed. The solution of the equations involved may give rise to numbers which exceed the range of common computing standards, for example limited by quadruple precision computing to an upper limit of 10^4932 and a lower limit of 10^-4932 respectively. For the stress analysis tool used, the stress descriptors are exponential functions which can exceed both upper and lower floating point limits simultaneously. This arises when more accurate models are required, necessitating the inclusion of more terms from the infinite series.

The "large number problem" (either excessively large or excessively small values) occurs when stress description terms in the solution equations exceed the floating point limit of the computing device (usually double or quadruple precision computing). For the stress analysis tool used, the stress descriptors may be exponential functions which can rapidly exceed both upper and lower floating point limits simultaneously. This arises when more accurate models are required, necessitating the inclusion of more terms from the series.

It is an object of the present invention to provide a method and system that resolves the above described problems.

### Summary of the Invention

According to the invention there is provided, as set out in the appended claims, a method of analysing the mechanical stress of an object using a computing device, said method comprising the steps of:
arranging a plurality of values representative of stress descriptors of said object,
having a plurality of rows and columns of values;
applying a different scaling factor to each row and applying a different scaling factor to each column;
generating an array from said scaled rows and columns;
storing the scaling factors for each row and each column;
processing the scaled array by multiplying by a vector representative of boundary conditions to provide a vector of system unknowns; and
determining stress values of said object from said stress descriptors by removing any errors of said processed array by using one or more of said stored scaling factors.

The method of scaling which uses differing scales for individual rows of the arrays, and by further using differing scales for individual columns of the arrays allows for the removal of errors. The column scaling factors are retained in the system memory until the output of the analysis has been computed. These outputs continue to be in error but the elements of the output from the analysis are corrected by incorporating the retained scaling factors so as to deliver the correct specific stresses at each location in the structure. This method and system of representing structural stresses ensures that the limitations of the computing device do not give rise to erroneous determination of stresses, irrespective of the degrees of accuracy determined by the user as his requirement.

In the present invention a method is described of scaling arrays by using differing scales for individual rows of the arrays, by further using differing scales for individual columns of the arrays, by incorporating these latter scaling factors into the elements of the output from the analysis, and by retaining them until the specific stresses at each location in the structure are about to be finally determined. This method and system of representing structural stresses ensures that the limitations of the computing device do not give rise to erroneous determination of stresses. The invention allows analysis of stress distributions to any specified spatial resolution, with any specified degree of accuracy, with certainty.

In one embodiment removing any errors in said processed array comprises the step of scaling the stress vector set by the inverse of the associated column scaling value.

In one embodiment arrays of values in which some values would ordinarily exceed the floating point limit of the computing device may be subjected to arithmetical operations without exceeding the computational limits of the computing device

In one embodiment the values are expressed in exponential form and the scaling factors are applied to the exponent part of each value. The scaling factors can be applied solely to the exponent part of each value.

In one embodiment the array is structured as a diagonally symmetrical array allowing array transposition as a means of defining scaling factors.

In one embodiment of the present invention provides a method of manipulating arrays of large and/or small numbers which are likely to exceed the floating point limit of the computing machine, in such a way that the outputs of the manipulations are accurate to any degree desired by the user.

A first difference between the invented solution and other solutions is the separate scaling of the columns of the arrays, each by a different scaling factor.

A second difference is the deferment of the re-adjustment of the representations of stress until they are being used in the determination of the actual stress values.

The representations of stress are stored in the computing device in logarithmic form. A third difference between the invented solution and other solutions is the scaling only of the exponents of the representations of stress. Previous attempts at scaling of logarithmic representations have had the effect of scaling the mantissa of the representations.

In a further embodiment of the present invention there is provided a computer implemented system for analysing the mechanical stress of an object, comprising:
one or more processors;
at least one memory;
at least one input/output device;
means for arranging a plurality of values representative of stress descriptors of said object, having a plurality of rows and columns of values;
means for applying a different scaling factor to each row and applying a different scaling factor to each column;
means for generating an array from said scaled rows and columns;
storing the scaling factors for each row and each column in at least one memory;
said at least one processor is adapted to process the scaled array by multiplying by a vector representative of boundary conditions; and
means for determining accurate stress values of said object from said stress vector set by removing any errors of said processed array by using one or more of said stored scaling factors.

The proposed system and method provides a method whereby arrays of numbers with values of any magnitude may be subjected to arithmetical operations without exceeding the computational limits of the computing device. This removes the upper and lower floating point as limitations of the number to be calculated.

The system and method can be implemented in a stress analysis tool providing the following specific advantages to the process over prior art. The invention allows the analysis of stresses in bimaterial beams to be performed to any accuracy (difference between actual values and calculated values of stress) and resolution (precision of location) with certainty (100% confidence that both accuracy and resolution are truly satisfied).

This invention allows the implementation of the stress analysis tool using arrays ordinarily employing unlimitedly large or unlimitedly small numbers. The tool allows an inbuilt estimate of the accuracy of the stress solutions of various objects. The tool can be configured easily and quickly for the study of the stresses in varying beam geometries, temperature changes or material properties. The tool can be used to carry out parametric analysis in which any of these parameters can be varied.

The invention allows the user to determine the degree of accuracy required in the stress analysis, and to establish array sizes appropriate to that accuracy.

In another embodiment of the present invention there is provided method of analysing an object using a computing device, said method comprising the steps of:
arranging a plurality of values representative of descriptors of said object,
having a plurality of rows and columns of values;
applying a different scaling factor to each row and applying a different scaling factor to each column;
generating an array from said scaled rows and columns;
storing the scaling factors for each row and each column;
processing the scaled array by multiplying by a vector representative of boundary conditions to provide a vector of system unknowns; and
determining values of said object from said descriptors by removing any errors of said processed array by using one or more of said stored scaling factors.

In one embodiment removing any errors in said processed array comprises the step of scaling the stress vector set by the inverse of the associated column scaling value.

In a further embodiment of the invention there is provided a computer implemented system for analysing an object, comprising:
one or more processors;
at least one memory;
at least one input/output device;
means for arranging a plurality of values representative of descriptors of said object, having a plurality of rows and columns of values;
means for applying a different scaling factor to each row and applying a different scaling factor to each column;
means for generating an array from said scaled rows and columns;
storing the scaling factors for each row and each column in the at least one memory;
said at least one processor is adapted to process the scaled array by multiplying by a vector representative of boundary conditions; and
means for determining accurate values of said object from said descriptors by removing any errors of said processed array by using one or more of said stored scaling factors such that all resultant values are within the floating point limit of the computer implemented system.

There is also provided a computer program comprising instructions for causing a computer to carry out the above method which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1: illustrates the schematic configuration of a system and method in which arrays of numbers exceeding the computational limit of the computing device are processed in a computing apparatus;
Figure 2: Prior art using finite element analysis processed in computing apparatus to give indeterminate medium accuracy output;
Figure 3: Prior art processed in a computing apparatus using either no scaling or elementary row operator scaling to give only determinate low or medium accuracy output;
Figure 4: A flowchart illustrating the sequence of operations within the hardware for the system in Fig 1 resulting in determinate high accuracy output;
Figure 5: illustrates peeling stress field near the interface on the free edge of a bimaterial beam and the model accuracy to scale; and
Figure 6: Extrapolation of Double and Quadruple Precision floating point limits for a bi-material beam.

### Detailed Description of the Drawings

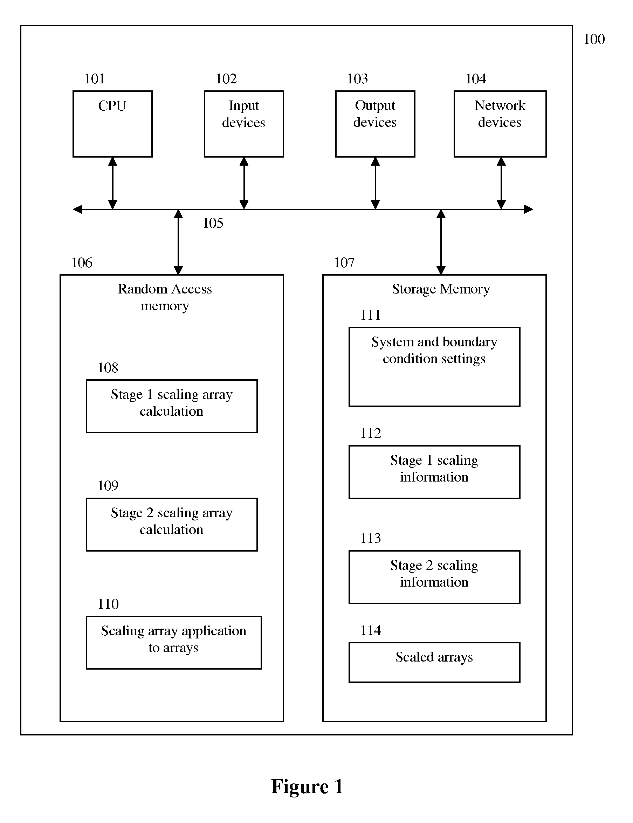

Figure 1 is a block diagram of system 100 that can be embodied in a computing apparatus, for example a standalone desktop PC. The system 100 generally includes: one or more processing units (CPU's) 101, one or more input devices 102, display or other output devices 103, possibly network devices 104 and one or more communication buses, 105, for interconnecting these components. The communication buses may include circuitry (sometimes called a chipset) that interconnects and controls communications between system components. The system also includes random access memory 106 and storage memory 107.

Random access memory, 106, holds amongst other things modules 108, 109 and 110. The apparatus 108 is the module used to calculate Stage 1 scaling arrays. Apparatus 109 is the module to calculate Stage 2 scaling arrays. Apparatus 110 is the module used to apply scaling arrays to the stress representation arrays.

Storage memory, 107, stores amongst other things arrays for use in the system. Apparatus 111 holds system settings and boundary condition information for use at the application stage. Apparatus 112 may be provided to store Stage 1 scaling arrays for possible use at the application stage. Apparatus 113 stores Stage 2 scaling arrays for use at the application stage. Apparatus 114 holds scaled arrays for use in other modules. The storage memory may comprise of memory on silicon chips, memory on magnetic disk, or any other form of computer readable memory.

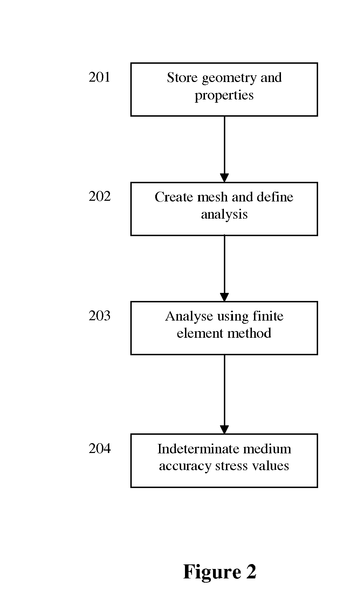

Figure 2 is a flowchart illustrating the system of prior art using finite element analysis processed in computing apparatus to give indeterminate medium accuracy output. Step 201 is the system for storing the geometric and material properties of the underlying application. Step 202 is the system for creating a mesh to represent the application and defining the analysis for use on the application stored in step 201. Step 203 is the analysis of the system using finite element method. Step 204 is the resolution of the system stresses to an indeterminate medium accuracy solution.

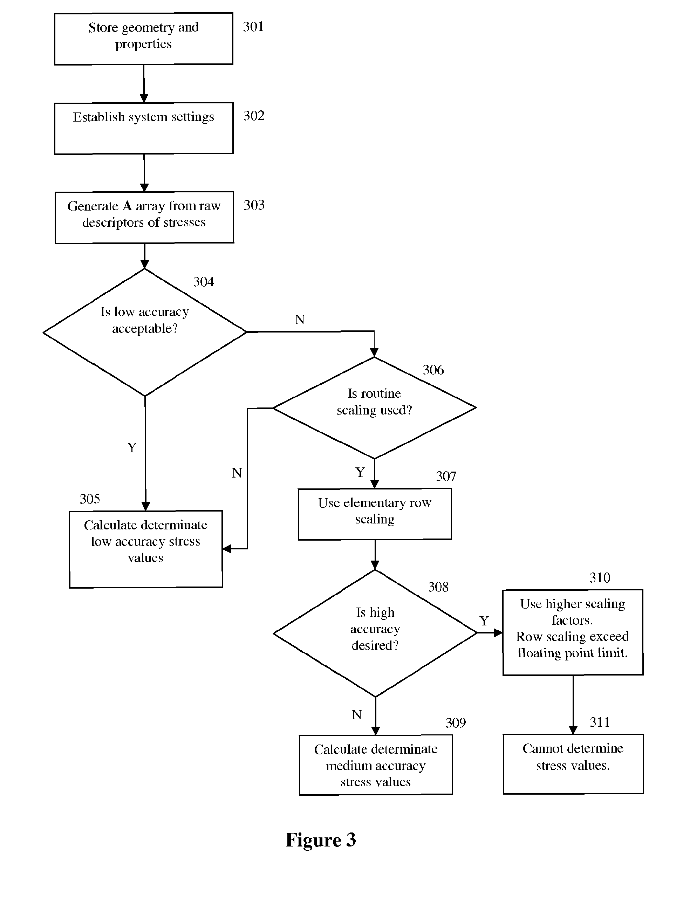

Figure 3 is a flowchart illustrating the process steps in prior art processed in a computing apparatus using either no scaling or elementary row operator scaling to give only determinate low or determinate medium accuracy output. Step 301 is the system for storing the geometric and material properties of the underlying application. Step 302 is the module for establishing the system settings. These are the accuracy limit of the system and the associated array sizes as well as any settings required for later calculations. Step 303 is the generation of the initial array from the raw stress descriptors. This is so as to represent the properties of the engineering structure to be analysed. Step 304 is the option to truncate the solution at a determinate low accuracy solution. If the determinate low accuracy solution is sufficient, the system moves to step 305. If insufficient, the system moves to step 306. Step 305 is the completion of the system by computing a determinate low accuracy solution. Step 306 is the option to apply routine scaling (most likely elementary row operations). If scaling is desired the system moves to step 307, otherwise the system moves to step 305 previously described. Step 307 is the use of elementary row operations to scale the array. Step 308 is the option to attempt to acquire a high accuracy determinate solution. If a determinate medium accuracy solution is sufficient, the system moves to step 309. If insufficient, the system moves to step 310. Step 309 is the completion of the system by computing a determinate medium accuracy solution. Step 310 is the use of higher scaling factors than previous steps. The results exceed the floating point limit of the computing device and consequently incorporate irrecoverable infinities. Step 311 is the termination of the solution without determining a stress value due to the presence of infinities in solution arrays.

Referring now to operation of the invention, a linear system for the stresses in a bi-material beam is solved, in which arrays of numbers with values of any magnitude may be subjected to arithmetical operations without exceeding the computational limits of the computing device. The set of arrays **A** acts on a set of vectors of unknowns x to produce a set of vectors of known constants **b,** i.e. **A.x=b.** The system of numbers is solved to find the unknowns **x.**

The invention relies on the use of scaling factors before the arrays' elements are formed. The purpose is to ensure that the value of the array elements remain within the floating point limit of the computer. Firstly, an approximate Stage 1 scaling factor array is calculated. This array is applied to the stress descriptors, prior to them being calculated. Each of the elements in a row of an array and the corresponding element of the constants vector b in the equation are scaled by a constant value for the row. Thus each row remains valid in the array equation, and the value of the unknown element in that row remains unchanged. Each row gets a different scaling factor. However this alone is not sufficient to reduce the values which the elements would ultimately have to within the floating point limit of the computing device.

In the invention the columns of the array are scaled in a somewhat similar way. A different scaling factor is used for each column. This difference changes individual elements in a row differently; as a result when the unknown represented by that column is solved for, the value of the unknown will be incorrect. The resulting set of simultaneous equations represented by the arrays does not any longer correspond to the original equations. The solution of the unknown vector x is not equivalent to the solution of the original stress problem.

However, the invention takes advantage of the fact that each element in the solution of the unknown vector x will have been altered by the scaling factor of the associated column in the array. To compensate for this an additional step is carried out while the resulting solution vector is being used to calculate stress values - which are arranged in a similar vector form. The stress descriptors are each scaled by the inverse of the associated column scaling factors. The amended vector set of stresses is then identical to the stress result had the original scaling not been done in the first instance. It will be appreciated that the invention can be improved by refinements at various stages of the procedure.

Column and row scaling factors are both essential to the invention, because it proved insufficient to scale the matrices using row scaling alone. The system provides means for carrying an incorrect array of unknowns into the calculation of the stress descriptors, and to carry out the unscaling at that level to provide the correction, when the amended values would be within the limits of the computer.

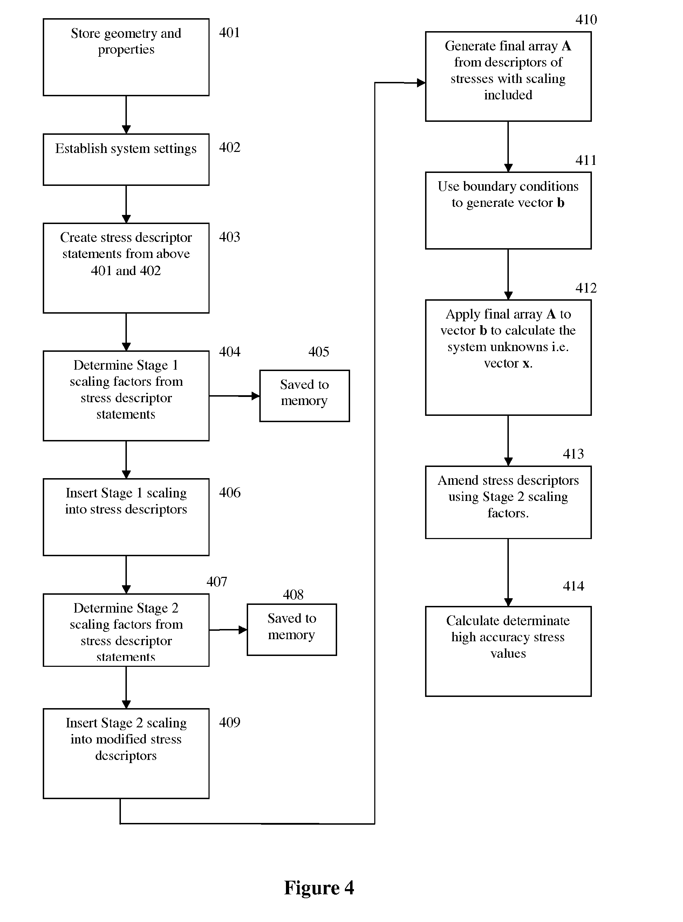

Figure 4 is a flowchart representing a computational system implemented in apparatus 100 as described in Fig 1 for a system and method in which arrays of numbers with values of any magnitude may be subjected to arithmetical operations without exceeding the computational limits of the computing device, according to certain embodiments of the invention. Computational apparatus 100 may be governed by instructions that are stored in a computer readable storage medium and that are executed by one or more processors of one or more servers. Each of the operations shown in Fig 4 may correspond to instructions stored in a computer memory or computer readable storage medium. The computer readable storage medium may include a magnetic or optical disk storage device, solid state storage devices such as Flash memory, or other non-volatile memory device or devices. The computer readable instructions stored on the computer readable storage medium may be in source code, assembly language code, object code, or other instruction format that is interpreted by one or more processors.

Figure 4 is a flowchart illustrating the process steps in one preferred embodiment of the present invention. Step 401 is the module for inputting boundary conditions. These take the form of the underlying geometry, material property and other physical properties of the application to be analysed (Boundary properties are saved to module 111 of storage memory 107). Step 402 is the module for inputting and defining system settings. These are the accuracy limit of the system and the associated array sizes as well as any settings required for later calculations (System settings are saved to module 111 of storage memory 105). Step 403 is the module for the creation of the stress descriptor statements from the boundary conditions and system settings established in steps 401 and 402. Step 404 consists of module 106 of apparatus 100 executing instructions contained therein for the purpose of defining the Stage 1 scaling factors. These scaling factors relate to the scaling of rows. In step 405 these scaling factors pᵢ are saved to memory module 112. Step 406 consists of module 108 of apparatus 100 executing instructions contained therein for the purpose of applying the Stage 1 scaling factors to the stress descriptors, one factor per row to be formed in array A, thereby scaling the rows of the final completed array. Step 407 consists of module 109 of apparatus 100 executing instructions contained therein for the purpose of defining the Stage 2 scaling factors. These scaling factors relate to the scaling of columns. In Step 408 these scaling factors pⱼ are saved to memory module 113. Step 409 consists of module 110 of apparatus 100 executing instructions contained therein for the purpose of applying the Stage 2 scaling factors to the stress descriptors of array **A,** one factor per column to be formed in array **A,** thereby scaling the columns of the final completed array. This introduces errors into the processes associated with array **A** at step 410. Step 410 is the generation of the **A** array. This is so as to represent the mechanical and geometric properties of the engineering structure to be analysed. Stage 1 and Stage 2 scaling factors had been embedded in stress descriptors array A at steps 406 and 409. Step 411 consists of the use of boundary conditions inputted in step 401 to generate vector **b** (i.e. vector **b** is the means by which the boundary conditions are carried into the solution). Step 412 consists of applying array **A** to vector **b** to calculate the system unknowns i.e. vector x. Vector x carries errors which are the consequence of column scaling. Step 413 amends the stress descriptors to compensate correspondingly for the errors in vector x using the stage 2 Scaling factors. Step 414 uses these stress descriptors to calculate determinate high accuracy stress values. The resultant stress field is accurate to the predetermined level.

Each of the above identified elements may be stored in one or more of the previously mentioned memory devices, and corresponds to a set of instructions for performing a function described above. The above identified modules or programs (i.e. sets of instructions) need not be implemented as separate software programs, procedures or modules, and thus various subsets of these modules may be combined or otherwise rearranged in various embodiments. In some embodiments, memory 106 and 107 may store a subset of the modules and data structures identified above. Furthermore, memory 106 and 107 may store additional modules and data structures not described above.

Although Fig 4 shows a system and method in which arrays of numbers with values of any magnitude may be subjected to arithmetical operations without exceeding the computational limits of the computing device, Fig 4 is intended more as functional description of the various features which may be present in a set of computational systems than as a structural schematic of the embodiments described herein. In practice, and as recognized by those of ordinary skill in the art, items shown separately could be combined and some items could be separated. For example, some items shown separately in Fig 4 could be implemented on a single computational system and single items could be implemented by one or more computational systems. The actual number of computational systems used to implement a system and method in which arrays of numbers with values of any magnitude may be subjected to arithmetical operations without exceeding the computational limits of the computing device, and how features are allocated among them will vary from one implementation to another.

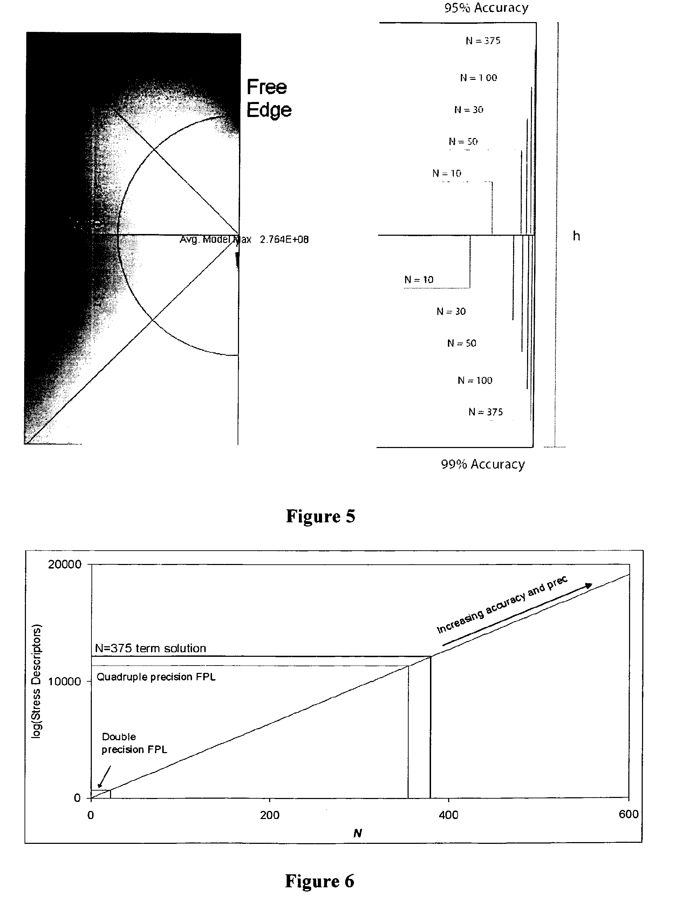

Figure 5 shows on the left hand side the normal stress field near the interface on the free edge of a bimaterial beam. The point denoted 2.764e8 marks the location of the stress singularity discussed in the background section. The right hand side of Fig 5 shows the model accuracy of the current embodiment to scale for both 95% (red) and 99% accuracy (blue) with 100% certainty as a function of the number of terms retained from the infinite series.

Figure 6 shows an extrapolation of Double and Quadruple Precision floating point limits for a sample bimaterial beam. The current embodiment has been successfully implemented and solved for N = 375 terms retained from the infinite series. This allows greater accuracy with certainty, than would ordinarily be available on the computing device used.

It will be appreciated that in the context of the present invention the term 'object' should be interpreted broadly and is to be interpreted to cover any engineering application that requires analysis requiring large number array analysis, for example, and not limited to, materials, physical structures, environments, fluid dynamics, and/or any mechanical/electronic systems.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

In the specification the terms "comprise, comprises, comprised and comprising" or any variation thereof and the terms "include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A method of analysing the mechanical stress of an object using a computing device, said method comprising the steps of:
arranging a plurality of values representative of stress descriptors of said object,
having a plurality of rows and columns of values;
applying a different scaling factor to each row and applying a different scaling factor to each column;
generating an array from said scaled rows and columns;
storing the scaling factors for each row and each column;
processing the scaled array by multiplying by a vector representative of boundary conditions to provide a vector of system unknowns; and
determining stress values of said object from said stress descriptors by removing any errors of said processed array by using one or more of said stored scaling factors.

2. The method of claim 1 wherein removing any errors in said processed array comprises the step of scaling the stress descriptors set by the inverse of the associated column scaling value.

3. The method of claim 1 or 2 wherein arrays of values comprise values of any magnitude may be subjected to arithmetical operations without exceeding the computational limits of the computing device

4. The method of any preceding claim wherein the values are expressed in exponential form and the scaling factors are applied to the exponent part of each value.

5. The method of claim 4, wherein the scaling factors are applied solely to the exponent part of each value.

6. The method of any preceding claim wherein the array is structured as a diagonally symmetrical array allowing array transposition as a means of defining scaling factors.

7. A computer readable storage medium storing one or more programs configured for execution by a computer, the one or more programs comprising instructions to execute the processing steps set out in any of claims 1 to 6.

8. The computer readable storage medium storing one or more programs as claimed in claim 7 embodied on a record medium, embodied on a carrier signal or embodied on a read-only memory.

9. A computer implemented system for analysing the mechanical stress of an object, comprising:
one or more processors;
at least one memory;
at least one input/output device;
means for arranging a plurality of values representative of stress descriptors of said object, having a plurality of rows and columns of values;
means for applying a different scaling factor to each row and applying a different scaling factor to each column;
means for generating an array from said scaled rows and columns;
storing the scaling factors for each row and each column in the at least one memory;
said at least one processor is adapted to process the scaled array by multiplying by a vector representative of boundary conditions; and
means for determining accurate stress values of said object from said stress descriptors by removing any errors of said processed array by using one or more of said stored scaling factors such that all resultant values are within the floating point limit of the computer implemented system.

10. The system of claim 9 wherein removing any errors in said processed array comprises means for scaling the stress descriptors by the inverse of the associated column scaling value.

11. The system of claim 9 or 10 wherein arrays of values comprise values of any magnitude may be subjected to arithmetical operations without exceeding the computational limits of the computer implemented system.

12. The system of any of claims 9 to 11 wherein the values are expressed in exponential form and the scaling factors are applied to the exponent part of each value.

13. The system as claimed in claim 12 wherein the scaling factors are applied solely to the exponent part of each value.

14. The system as claimed in any of claims 8 to 13 wherein the array is structured as a diagonally symmetrical array allowing array transposition as a means of defining scaling factors.
